## Europäisches Patentamt

## European Patent Office

## Office européen des brevets

(19)

(11) **EP 1 612 944 A1**

(12) **EUROPÄISCHE PATENTANMELDUNG**

(43) Veröffentlichungstag:
**04.01.2006 Patentblatt 2006/01**

(51) Int Cl.:
**H03L 7/18** *(2006.01)*     **G01F 23/284** *(2006.01)*

(21) Anmeldenummer: **05010425.6**

(22) Anmeldetag: **13.05.2005**

(84) Benannte Vertragsstaaten:
**AT BE BG CH CY CZ DE DK EE ES FI FR GB GR HU IE IS IT LI LT LU MC NL PL PT RO SE SI SK TR**
Benannte Erstreckungsstaaten:
**AL BA HR LV MK YU**

(30) Priorität: **01.07.2004 DE 102004032130**

(71) Anmelder: **KROHNE MESSTECHNIK GMBH & CO. KG**
**47058 Duisburg (DE)**

(72) Erfinder: **Musch, Thomas, Dr.-Ing.**
**45481 Mülheim an der Ruhr (DE)**

(74) Vertreter: **Gesthuysen, von Rohr & Eggert**
**Patentanwälte**
**Huyssenallee 100**
**45128 Essen (DE)**

(54) **Frequenzsynthesizer und Verfahren zum Betrieb eines Frequenzsynthesizers**

(57) Dargestellt und beschrieben sind ein Frequenzsynthesizer sowie ein Verfahren zum Betrieb eines Frequenzsynthesizers, insbesondere für einen Zeitbasisgenerator eines Füllstandsmeßgeräts, das nach dem Radarprinzip arbeitet. Mit dem Frequenzsynthesizer sollen ein erstes Frequenzsignal und ein zweites Frequenzsignal ausgegeben werden, die eine geringe Differenzfrequenz zueinander aufweisen, wofür ein mit einer Referenzfrequenz betriebener Referenzoszillator (1) und ein auf einer Regelfrequenz geregelter Regeloszillator (2) vorgesehen sind. Erfindungsgemäß ist dem Referenzoszillator (1) ein erster Frequenzteiler (3) mit dem Teilungsfaktor $V_1$ nachgeschaltet, und dem Regeloszillator (2) ist ein zweiter Frequenzteiler (4) mit dem Teilungsfaktor $V_2$ nachgeschaltet, wobei der erste Frequenzteiler (3) und der zweite Frequenzteiler (4) der Ausgabe des ersten Frequenzsignals bzw. des zweiten Frequenzsignals dienen. Damit wird ein stabiler Frequenzsynthesizer bereitgestellt, der eine große Bandbreite der Phasenregelung aufweist, was eine extrem kurze Einschwingzeit als auch eine breitbandige Unterdrückung des Phasenrauschens bedeutet.

**Beschreibung**

Die Erfindung betrifft einen Frequenzsynthesizer, insbesondere für einen Zeitbasisgenerator eines Füllstandsmeßgeräts, das nach dem Radarprinzip arbeitet, zur Ausgabe eines ersten Frequenzsignals und eines zweiten Frequenzsignals, die eine geringe Differenzfrequenz zueinander aufweisen, mit einem mit einer Referenzfrequenz betriebenen Referenzoszillator und einem auf eine Regelfrequenz geregelten Regeloszillator. Die Erfindung betrifft ferner ein Verfahren zum Betrieb eines Frequenzsynthesizers, insbesondere für einen Zeitbasisgenerator eines Füllstandsmeßgeräts, das nach dem Radarprinzip arbeitet, zur Ausgabe eines ersten Frequenzsignals und eines zweiten Frequenzsignals, die eine geringe Differenzfrequenz zueinander aufweisen, mit einem mit einer Referenzfrequenz betriebenen Referenzoszillator und einem auf eine Regelfrequenz geregelten Regeloszillator.

Ein solcher Frequenzsynthesizer sowie ein solches Verfahren zum Betrieb eines Frequenzsynthesizers sind z. B. aus der DE 102 44 348 A 1 bekannt. Insbesondere ist dort ein derartiger Frequenzsynthesizer beschrieben, bei dem der Regeloszillator mit seiner Regelfrequenz derart an die Referenzfrequenz des Referenzoszillators angebunden wird, daß die Referenzfrequenz und die Regelfrequenz eine kleine Frequenzdifferenz zueinander aufweisen, ohne daß dabei eine kleine Vergleichsfrequenz in Kauf genommen werden muß. In der Praxis hat sich jedoch gezeigt, daß die mit einem derartigen Frequenzsynthesizer erzielbare Stabilität sowie das damit verbundene Rauschverhalten noch verbesserungswürdig sind.

Dementsprechend ist es die Aufgabe der Erfindung, einen derartigen Frequenzsynthesizer sowie ein derartiges Verfahren zum Betrieb eines Frequenzsynthesizers anzugeben, mit denen ein stabiler Betrieb des Frequenzsynthesizers erzielt werden kann.

Ausgehend von dem eingangs beschriebenen Frequenzsynthesizer ist die zuvor hergeleitete und aufgezeigte Aufgabe dadurch gelöst, daß dem Referenzoszillator ein erster Frequenzteiler mit dem Teilungsfaktor $V_1$ nachgeschaltet ist und dem Regeloszillator ein zweiter Frequenzteiler mit dem Teilungsfaktor $V_2$ nachgeschaltet ist, die der Ausgabe des ersten Frequenzsignals bzw. des zweiten Frequenzsignals dienen.

Erfindungsgemäß werden also als erstes Frequenzsignal und zweites Frequenzsignal, zwischen denen eine geringe Differenzfrequenz bestehen soll, nicht direkt die Referenzfrequenz bzw. die Regelfrequenz ausgegeben, sondern solche Signale, deren Frequenzen gegenüber der Referenzfrequenz bzw. der Regelfrequenz heruntergeteilt sind. Gemäß einer bevorzugten Weiterbildung der Erfindung ist in diesem Zusammenhang auch vorgesehen, daß der Teilungsfaktor $V_1$ von dem Teilungsfaktor $V_2$ verschieden ist. Gemäß einer ganz bevorzugten Weiterbildung der Erfindung steht der Teilungsfaktor $V_1$ zu dem Teilungsfaktor $V_2$ in einem derartigen Verhältnis, das durch den Quotienten zweier kleiner ganzer Zahlen gegeben ist, wobei die ganzen Zahlen vorzugsweise unter 20, ganz bevorzugt unter 10 liegen.

Mit dieser bevorzugten Weiterbildung der Erfindung ist verbunden, daß der Referenzoszillator und der Regeloszillator mit deutlich voneinander verschiedenen Frequenzen arbeiten, während im Stand der Technik, von dem die vorliegende Erfindung ausgeht, vorgesehen ist, daß die Referenzfrequenz und die Regelfrequenz sehr nahe beieinander liegen. Dies hat unter anderem den Vorteil, daß sich die beiden Oszillatoren, nämlich der Referenzoszillator und der Regeloszillator, einander deutlich weniger durch Verkopplungseffekte stören als aus dem Stand der Technik bekannt.

Die Ankopplung des Regeloszillators an den Referenzoszillator kann auf verschiedene, unter anderem aus dem Stand der Technik bekannte Techniken erfolgen. Gemäß einer bevorzugten Weiterbildung der Erfindung ist vorgesehen, daß der Referenzoszillator zur Ausgabe des Referenzfrequenzsignals mit einem dritten Frequenzteiler mit dem Teilungsfaktor L sowie mit einem vierten Frequenzteiler mit dem Teilungsfaktor M verbunden ist, der Regeloszillator zur Ausgabe des Regelfrequenzsignals mit einem fünften Frequenzteiler mit dem Teilungsfaktor N verbunden ist, ein Mischer vorgesehen ist, der zur Zuführung des von dem vierten Frequenzteiler ausgegebenen Frequenzsignals und des von dem fünften Frequenzteiler ausgegebenen Frequenzsignals mit dem vierten Frequenzteiler und dem fünften Frequenzteiler verbunden ist, und ein Phasenfrequenzdiskriminator vorgesehen ist, der zur Zuführung des von dem Mischer ausgegebenen Mischdifferenzfrequenzsignals mit dem Mischer und zur Zuführung des von dem dritten Frequenzteiler ausgegebenen Vergleichsfrequenzsignals mit dem dritten Frequenzteiler verbunden ist, wobei der Regeloszillator zur Zuführung des von dem Phasenfrequenzdiskriminator ausgegebenen Frequenzsignals mit dem Phasenfrequenzdiskriminator, vorzugsweise über einen Schleifenfilter, verbunden ist.

Gemäß einer bevorzugten Weiterbildung der Erfindung ist dabei insbesondere vorgesehen, daß die Differenzfrequenz, also die Differenz zwischen der Frequenz des ersten Frequenzsignals und der Frequenz des zweiten Frequenzsignals, wenigstens um den Faktor 10, vorzugsweise wenigstens um den Faktor 30 und ganz besonders bevorzugt wenigstens um den Faktor 100, kleiner gewählt ist als die Vergleichsfrequenz, also die Frequenz des von dem dritten Frequenzteiler ausgegebenen Vergleichsfrequenzsignals.

Im übrigen ist gemäß einer bevorzugten Weiterbildung der Erfindung vorgesehen, daß die Teilungsfaktoren derart gewählt sind, daß der Term

$$V_1\,N\,L \pm V_1\,M\,N - V_2\,M\,L$$

ganzzahlig ist, vorzugsweise vom Betrag her 1 ergibt.

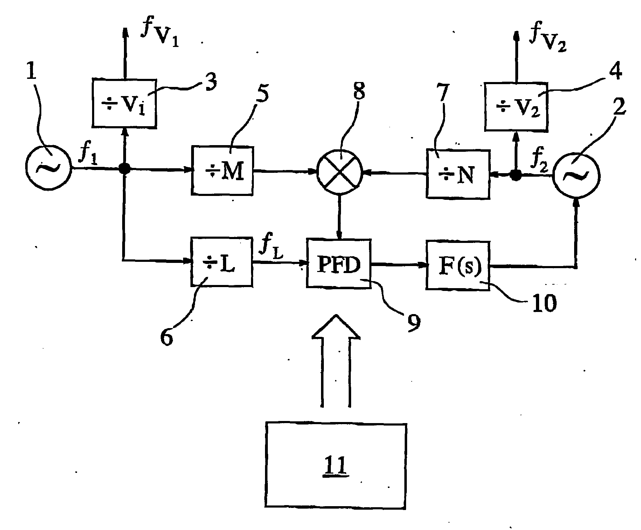

Für die damit verbundenen Vorteile wird auf die weiter unten folgende detaillierte Beschreibung eines bevorzugten Ausführungsbeispiels der Erfindung unter Bezugnahme auf die Zeichnung verwiesen.

Ausgehend von dem eingangs beschriebenen Verfahren zum Betrieb eines Frequenzsynthesizers ist die weiter oben hergeleitete und aufgezeigte Ausgabe dadurch gelöst, daß die Differenz zwischen der Referenzfrequenz und der Regelfrequenz wenigstens eine Größenordnung größer ist als die Differenzfrequenz zwischen dem ersten Frequenzsignal und dem zweiten Frequenzsignal.

Wesentliches Element des erfindungsgemäßen Verfahrens zum Betrieb eines Frequenzsynthesizers ist also, daß, anders als im Stand der Technik, die beiden Oszillatoren nicht mit fast gleichen, sondern mit deutlich voneinander verschiedenen Frequenzen betrieben werden. In diesem Zusammenhang ist gemäß einer bevorzugten Weiterbildung der Erfindung vorgesehen, daß das von dem Referenzoszillator ausgegebene Referenzfrequenzsignal zur Erzeugung des ersten Frequenzsignals um den Teilungsfaktor $V_1$ heruntergeteilt wird und das von dem Regeloszillator ausgegebene Regelfrequenzsignal zur Erzeugung des zweiten Frequenzsignals um den Teilungsfaktor $V_2$ heruntergeteilt wird. Dabei ist, wie zuvor schon im Zusammenhang mit dem erfindungsgemäßen Frequenzsynthesizer angesprochen, gemäß einer bevorzugten Weiterbildung der Erfindung auch vorgesehen, daß die Teilungsfaktoren voneinander verschieden sind und sich wie zwei kleine ganze Zahlen zueinander verhalten, wobei die ganzen Zahlen vorzugsweise kleiner als 20, ganz besonders bevorzugt kleiner als 10 sind.

Gemäß einer bevorzugten Weiterbildung der Erfindung ist weiterhin vorgesehen, daß zum Herunterteilen des Referenzfrequenzsignals bzw. des Regelfrequenzsignals ein erster Frequenzteiler mit dem Teilungsfaktor $V_1$ und ein zweiter Frequenzteiler mit dem Teilungsfaktor $V_2$ vorgesehen sind. Eine bevorzugte Weiterbildung der Erfindung ist im übrigen dadurch gegeben, daß der Referenzoszillator das Referenzfrequenzsignal auf einen dritten Frequenzteiler mit dem Teilungsfaktor L sowie auf einen vierten Frequenzteiler mit dem Teilungsfaktor M ausgibt, der Regeloszillator das Regelfrequenzsignal auf einen fünften Frequenzteiler mit dem Teilungsfaktor N ausgibt, ein Mischer vorgesehen ist, dem das von dem vierten Frequenzteiler ausgegebene Frequenzsignal und das von dem fünften Frequenzteiler ausgegebene Frequenzsignal zugeführt wird, und ein Phasenfrequenzdiskriminator vorgesehen ist, dem das von dem Mischer ausgegebene Mischdifferenzfrequenzsignal und das von dem dritten Frequenzteiler ausgegebene Vergleichsfrequenzsignal zugeführt wird, wobei das von dem Phasenfrequenzdiskriminator ausgegebene Frequenzsignal dem Regeloszillator, vorzugsweise über einen Schleifenfilter, zugeführt wird. Im übrigen sind natürlich auch andere, aus dem Stand der Technik bekannte Vorgehensweisen möglich, um den Regeloszillator an den Referenzoszillator frequenzmäßig in vorbestimmter Weise anzubinden.

Eine bevorzugte Weiterbildung der Erfindung besteht ferner darin, daß die Differenzfrequenz wenigstens um den Faktor 10, vorzugsweise wenigstens um den Faktor 30, ganz besonders bevorzugt wenigstens um den Faktor 100 kleiner gewählt ist als die Vergleichsfrequenz. Im übrigen ist es besonders bevorzugt, daß die Teilungsfaktoren derart gewählt sind, daß der Term

$$V_1 \, N \, L \pm V_1 \, M \, N - V_2 \, M \, L$$

ganzzahlig ist, ganz besonders bevorzugt vom Betrag her 1 ergibt.

Bei Frequenzsynthesizern der eingangs beschriebenen Art stellt sich auch die Aufgabe, diese in einem Zweileitergerät, wie einem Zweileiter-Füllstandsmeßgerät, verwenden zu können. Bei den hier angesprochenen Zweileitergeräten handelt es sich um solche Geräte, die über eine Zweileiterschnittstelle gleichzeitig ihr Meßsignal abgeben und mit elektrischer Energie versorgt werden. Dabei wird das Meßsignal typischerweise durch einen Strom im Bereich zwischen 4 und 20 mA bei einer Gleichspannung von z. B. 24 V übertragen. Bei Ausgabe des kleinsten Meßwerts, also bei Ausgabe von 4 mA, steht damit lediglich eine elektrische Leistung von knapp 100 mW zur Verfügung. Diese beschränkte elektrische Leistung bei Zweileitergeräten macht Maßnahmen erforderlich, die die Energieaufnahme der Zweileitergeräte derart beschränken, daß gleichwohl ein Meßbetrieb aufgenommen und aufrechterhalten werden kann.

Damit ist es auch die Aufgabe der Erfindung, einen derartigen Frequenzsynthesizer sowie ein derartiges Verfahren zum Betrieb eines Frequenzsynthesizers anzugeben, die für einen Zweileiterbetrieb geeignet sind.

Ausgehend von dem eingangs beschriebenen Frequenzsynthesizer ist die zuvor hergeleitete und aufgezeigte Aufgabe dadurch gelöst, daß eine Ansteuereinrichtung zum intermittierenden Betrieb des Frequenzsynthesizers mit einer Einschwingzeit von weniger als 50 ms vorgesehen ist.

Erfindungsgemäß ist also vorgesehen, daß der Frequenzsynthesizer nicht kontinuierlich betrieben wird, sondern immer nur dann eingeschaltet wird, wenn tatsächlich ein Meßbetrieb erfolgen soll. Insbesondere bei der Verwendung des erfindungsgemäßen Frequenzsynthesizers für einen Zeitbasisgenerator eines Füllstandsmeßgeräts, das nach dem Radarprinzip arbeitet, ist es dabei wesentlich, eine hinreichend geringe Einschwingzeit bereitzustellen, nämlich von weniger als 50 ms. Dies rührt im wesentlichen daher, daß typische Meßzeiten 200 ms bis herunter zu wenigen 10 ms betragen. Insofern ist es gemäß einer bevorzugten Weiterbildung der Erfindung vorgesehen, daß die Ansteuereinrichtung zum intermittierenden Betrieb des Frequenzsynthesizers eine Einschwingzeit von weniger als 25 ms, vorzugsweise von weniger als 10 ms und ganz besonders bevorzugt von weniger als 5 ms ermöglicht.

Weiterhin sind gemäß einer bevorzugten Weiterbildung der Erfindung ein erster Frequenzteiler mit dem Teilungsfaktor $V_1$ und ein zweiter Frequenzteiler mit dem Teilungsfaktor $V_2$ vorgesehen sind, wobei der erste Frequenzteiler zur Zuführung des Referenzfrequenzsignals mit dem Referenzoszillator verbunden ist, der zweite Frequenzteiler zur Zuführung des Regelfrequenzsignals mit dem Regeloszillator verbunden ist und der erste Frequenzteiler zur Ausgabe des ersten Frequenzsignals und der zweite Frequenzteiler zur Ausgabe des zweiten Frequenzsignals dient.

Gemäß einer bevorzugten Weiterbildung der Erfindung wird das Vorsehen der zuvor genannten Frequenzteiler dadurch ergänzt, daß der Referenzoszillator zur Ausgabe des Referenzfrequenzsignals mit einem dritten Frequenzteiler mit dem Teilungsfaktor L sowie mit einem vierten Frequenzteiler mit dem Teilungsfaktor M verbunden ist, der Regeloszillator zur Ausgabe des Regelfrequenzsignals mit einem fünften Frequenzteiler mit dem Teilungsfaktor N verbunden ist, ein Mischer vorgesehen ist, der zur Zuführung des von dem vierten Frequenzteiler ausgegebenen Frequenzsignals und des von dem fünften Frequenzteiler ausgegebenen Frequenzsignals mit dem ersten Frequenzteiler und mit dem zweiten Frequenzteiler verbunden ist, und ein Phasenfrequenzdiskriminator vorgesehen ist, der zur Zuführung des von dem Mischer ausgegebenen Mischdifferenzfrequenzsignals mit dem Mischer und zur Zuführung des von dem dritten Frequenzteiler ausgegebenen Vergleichsfrequenzsignals mit dem dritten Frequenzteiler verbunden ist, wobei der Regeloszillator zur Zuführung des von dem Phasenfrequenzdiskriminator ausgegebenen Frequenzsignals mit dem Phasenfrequenzdiskriminator, vorzugsweise über einen Schleifenfilter, verbunden ist.

Dabei ist weiterhin bevorzugt, daß die Differenzfrequenz wenigstens um den Faktor 10, vorzugsweise wenigstens um den Faktor 30, ganz besonders bevorzugt wenigstens um den Faktor 100 kleiner gewählt ist als die Vergleichsfrequenz. Gemäß einer bevorzugten Weiterbildung der Erfindung gilt für die Teilungsfaktoren, daß diese derart gewählt sind, daß der Term

$$V_1\,N\,L \pm V_1\,M\,N - V_2\,M\,L$$

ganzzahlig ist, vorzugsweise vom Betrag her 1 ergibt.

Ausgehend von dem eingangs beschriebenen Verfahren zum Betrieb eines Frequenzsynthesizers ist die weiter oben hergeleitete und aufgezeigte Aufgabe, nämlich die Bereitstellung eines Verfahrens zum Betrieb eines Frequenzsynthesizers, das auch für einen Zweileiterbetrieb geeignet ist, dadurch gelöst, daß der Frequenzsynthesizer intermittierend mit einer Einschwingzeit von weniger als 50 ms betrieben wird.

Bevorzugte Weiterbildungen dieses erfindungsgemäßen Verfahrens ergeben sich in Analogie zu den zuvor beschriebenen bevorzugten Weiterbildungen des erfindungsgemäßen Frequenzsynthesizers, der für einen Zweileiterbetrieb geeignet ist.

Im einzelnen gibt es nun eine Vielzahl von Möglichkeiten, die erfindungsgemäßen Frequenzsynthesizer sowie die erfindungsgemäßen Verfahren zum Betrieb der Frequenzsynthesizer auszugestalten und weiterzubilden. Dazu wird auf die den unabhängigen Patentansprüchen nachgeordneten Patentansprüche sowie auf die nachfolgende detaillierte Beschreibung eines bevorzugten Ausführungsbeispiels der Erfindung unter Bezugnahme auf die Zeichnung verwiesen. In der Zeichnung zeigt die einzige Figur schematisch den Aufbau eines Frequenzsynthesizers gemäß einem bevorzugten Ausführungsbeispiel der Erfindung.

Der dargestellte Frequenzsynthesizer gemäß dem vorliegend beschriebenen bevorzugten Ausführungsbeispiel der Erfindung ist insbesondere für einen Zeitbasisgenerator eines Füllstandsmeßgeräts geeignet, das nach dem Radar-prinzip arbeitet. Ein solches Füllstandsmeßgerät kann z. B. auf dem TDR-Meßprinzip (Time Domain Reflectometry) basieren. Das TDR-Meßprinzip ist z. B. aus dem Bereich der Kabelprüfung bekannt und weist Ähnlichkeiten mit der Funktionsweise von Radargeräten auf. Bei einem TDR-Füllstandsmeßgerät wird ein extrem kurzer elektrischer Impuls, geführt über einen oder zwei im wesentlichen gerade verlaufende elektrische Leiter, in einen Behälter ausgesandt, in dem sich ein Medium, wie eine Flüssigkeit, ein Pulver oder ein Granulat befindet, dessen Füllstand bestimmt werden soll. Der über die beiden Leiter in den Behälter ausgesandte kurze elektrische Impuls wird an der Oberfläche des Mediums reflektiert, und der reflektierte Anteil des kurzen elektrischen Impulses wird von einem Meßumformer des Meßgeräts wieder detektiert. Der reflektierte Anteil des kurzen elektrischen Impulses hängt von der Dielektrizitätszahl des Mediums ab und steigt mit dieser. Die Laufzeit des Signals ist dabei proportional zum Abstand des Meßumformers zur Oberfläche des in dem Behälter befindlichen Mediums. Sich verändernde Umgebungsbedingungen, wie ein steigender oder fallender Umgebungsdruck oder eine steigende oder fallende Temperatur, beeinträchtigen die Meßgenauigkeit des TDR-Füllstandsmeßgeräts nicht. Außerdem ist die Laufzeit des Signals unabhängig von der Dielektrizitätszahl des Mediums, an dem die Reflektion erfolgt.

Das TDR-Meßprinzip beruht somit darauf, daß die - unter Umständen sehr kurzen - Laufzeiten eines elektromagnetischen Signals gemessen werden. Ist der Behälter annähernd vollständig mit dem Medium gefüllt, so daß die Oberfläche des Mediums beispielsweise lediglich 15 cm unterhalb des Meßumformers des TDR-Füllstandsmeßgeräts liegt, beträgt die Gesamtlaufstrecke des elektromagnetischen Signals vom Meßumformer zur Oberfläche des Mediums und wieder zurück lediglich 30 cm, was einer Laufzeit des kurzen elektrischen Impulses von 1 ns entspricht. Um solch kurze Laufzeiten überhaupt messen zu können, bedient man sich eines Sampling-Verfahrens, für welches zwei hochfrequente Signale erzeugt werden, die zueinander eine vorbestimmte geringe Frequenzdifferenz aufweisen. Eine Messung wird dann derart durchgeführt, daß zu einem Zeitpunkt 0, zu dem die beiden Frequenzsignale gleichphasig schwingen, mit der Messung begonnen wird. Dabei gibt das höherfrequenter schwingende Signal den Takt für die Aussendung des eigentlichen Meßsignals, d. h. des kurzen elektrischen Impulses, in den Behälter an. So wird z. B. immer zu Beginn einer Periode des höherfrequent schwingenden Signals ein kurzer elektrischer Impuls generiert und in den Behälter ausgesandt. Das niedrigerfrequent schwingende Signals eilt dem höherfrequenter schwingenden Signal pro Schwingungsperiode um einen gewissen geringen Betrag nach. Damit wird ein zeitliches Raster definiert, das eine digitale Zeitbasis darstellt und mit der die Laufzeit des in den Behälter ausgesandten und an der Oberfläche des Mediums reflektierten kurzen elektrischen Impulses gemessen wird.

Der Frequenzsynthesizer gemäß dem vorliegend beschriebenen bevorzugten Ausführungsbeispiel der Erfindung ist nun in besonderem Maße für einen solchen Zeitbasisgenerator für ein Füllstandsmeßgerät, wie ein TDR-Füllstandsmeßgerät, geeignet, wobei sich im übrigen auch die Möglichkeit eines Zweileiterbetriebs eröffnet, wie im folgenden im Detail ausgeführt wird:

Wie der einzigen Figur entnehmbar, weist der Frequenzsynthesizer gemäß dem bevorzugten Ausführungsbeispiel der Erfindung folgenden Aufbau auf: Ein Referenzoszillator 1 wird mit einer Referenzfrequenz $f_1$ betrieben und gibt sozusagen die Referenz für einen an den Referenzoszillator 1 angekoppelten Regeloszillator 2 vor, es erfolgt nämlich eine Regelung des Regeloszillators 2 auf eine Regelfrequenz $f_2$, wie im folgenden ausgeführt. Zuvor sei darauf hingewiesen, daß dem Referenzoszillator 1 ein erster Frequenzteiler 3 mit dem Teilungsfaktor $V_1$ und dem Regeloszillator ein zweiter Frequenzteiler 4 mit dem Teilungsfaktor $V_2$ nachgeschaltet ist, die der Ausgabe des ersten Frequenzsignals $f_{V1}$ bzw. des zweiten Frequenzsignals $f_{V2}$ dienen. Zwischen dem ersten Frequenzsignal $f_{V1}$ und dem zweiten Frequenzsignal $f_{V2}$ existiert dann die schon angesprochene geringe Differenzfrequenz, die für den Zeitbasisgenerator für das Füllstandsmeßgerät erforderlich ist

Der prinzipielle Aufbau des Frequenzsynthesizers gemäß dem vorliegend beschriebenen bevorzugten Ausführungsbeispiel der Erfindung ist nun derart, daß der Referenzoszillator 1 zur Ausgabe des Referenzfrequenzsignals $f_1$ mit einem dritten Frequenzteiler 5 mit dem Teilungsfaktor L sowie mit einem vierten Frequenzteiler 6 mit dem Teilungsfaktor M verbunden ist, der Regeloszillator 2 zur Ausgabe des Regelfrequenzsignals $f_2$ mit einem fünften Frequenzteiler 7 mit dem Teilungsfaktor N verbunden ist, ein Mischer 8 vorgesehen ist, der zur Zuführung des von dem vierten Frequenzteiler 6 ausgegebenen Frequenzsignals und des von dem fünften Frequenzteiler 7 ausgegebenen Frequenzsignals mit dem vierten Frequenzteiler 6 und dem fünften Frequenzteiler 7 verbunden ist, und ein Phasenfrequenzdiskriminator 9 vorgesehen ist, der zur Zuführung des von dem Mischer 8 ausgegebenen Mischdifferenzfrequenzsignals mit dem Mischer 8 und zur Zuführung des von dem dritten Frequenzteiler 5 ausgegebenen Vergleichsfrequenzsignals $f_1$ mit dem dritten Frequenzteiler 5 verbunden ist, wobei der Regeloszillator 2 zur Zuführung des von dem Phasenfrequenzdiskriminators 9 ausgegebenen Frequenzsignals mit dem Phasenfrequenzdiskriminator 9 verbunden ist, nämlich über einen Schleifenfilter 10. Dabei sind folgende Teilungsfaktoren gewählt worden: M = 9, N = 11 und L = 496 oder 494, $V_1$ = 5 und $V_2$ = 6. Weiterhin wird der Referenzoszillator 2 mit einer Frequenz von 20 MHz betrieben, so daß sich folgendes ergibt:

Im eingeschwungenen Zustand gilt für die Frequenz $f_2$ des Regeloszillators 2:

$$f_2 = f_1\left(\frac{N}{M} \pm \frac{N}{L}\right),$$

für den Fall, daß die Regelfrequenz $f_2$ größer ist als die Referenzfrequenz $f_1$. Das Vorzeichen hängt dabei von den Frequenzverhältnissen am Mischer 8 ab, wobei das positive Vorzeichen gewählt werden muß, wenn

$$\frac{f_2}{N} > \frac{f_1}{M}$$

ist, und das negative Vorzeichen gewählt werden muß, wenn

$$\frac{f_2}{N} < \frac{f_1}{M}$$

ist.

Im Falle von L = 496 ergibt sich für die Regelfrequenz

$$f_2 = f_1 \bullet N\left(\frac{L-M}{ML}\right) = 24\,MHz + 896,05\,Hz,$$

und für den Fall, daß L = 494 gewählt worden ist, ergibt sich für die Regelfrequenz

$$f_2 = f_1 \bullet N(\frac{L-M}{ML}) = 24\,MHz - 899{,}686\,Hz.$$

Als Differenzfrequenz ergibt sich damit für den Fall L = 496

$$f_{r2} - f_{r1} = 149{,}342\overline{3}\,Hz$$

bzw. für den Fall L = 494

$$f_{r1} - f_{r2} = 149{,}947\overline{6}\,Hz.$$

Man erhält also eine geringe Differenzfrequenz zwischen dem ersten Frequenzsignal und dem zweiten Frequenzsignal von ca. 150 Hz, ohne daß auch der Referenzoszillator 1 und der Regeloszillator 2 mit solchen Frequenzen betrieben werden müssen, die ebenfalls nur eine entsprechend geringe Differenzfrequenz zueinander aufweisen. Statt dessen wird der Referenzoszillator 1 vorliegend mit 20 MHz betrieben, und der Regeloszillator 2 wird auf ca. 24 MHz geregelt, so daß eine deutlich größere Differenz zwischen der Referenzfrequenz und der Regelfrequenz vorliegt, was wiederum zu weniger Störungen durch Verkopplung des Regeloszillators 2 mit dem Referenzoszillator 1 führt.

Weiterhin ist für den vorliegend beschriebenen Frequenzsynthesizer gemäß dem bevorzugten Ausführungsbeispiel der Erfindung folgendes von wesentlicher Bedeutung:

Betrachtet man die Differenzfrequenz Δf in dem aus dem Stand der Technik bekannten Fall, daß die Regelfrequenz im wesentlichen der Referenzfrequenz entspricht, also keine dem Referenzoszillator 1 bzw. dem Regeloszillator 2 nachgeschaltete Frequenzteiler 3, 4 vorgesehen sind, so gilt

$$\Delta f = |f_1 - f_2|$$

$$= \left| f_1 - f_1 N(\frac{L-M}{LM}) \right|$$

$$= f_1 \bullet \left| \frac{ML - NL - MN}{ML} \right|.$$

Daraus folgt für die aus dem Stand der Technik bekannte Lösung die Bedingung, daß der Term ML-NL-MN ganzzahlig ist und vorzugsweise vom Betrag her 1 ergibt, um eine möglichst geringe Differenzfrequenz Δf zu erzielen.

Bei dem hier beschriebenen Frequenzsynthesizer gemäß dem bevorzugten Ausführungsbeispiel der Erfindung gilt für die Differenzfrequenz

$$\Delta f = f_1 \left| \frac{1}{V_1 V_2 ML} \right|,$$

wobei zur Erzielung einer möglichst geringen Differenzfrequenz Δf der Zähler bereits vom Betrag her zu 1 gesetzt worden ist. Die entsprechende Bedingung lautet vorliegend

$$V_1 ML \pm V_1 NM - V_2 NL = \pm 1.$$

Damit wird die geringstmögliche Differenzfrequenz Δf erzielt. Anders ausgedrückt genügen damit bei vorgegebener geringer Differenzfrequenz Δf, nämlich z. B. im wesentlichen derselben Differenzfrequenz Δf wie aus dem Stand der Technik bekannt, geringere Werte für die Teilungsfaktoren M, N und L um zu einem im wesentlichen gleichen Ergebnis zu kommen. Kleine Werte für diese Teilungsfaktoren sind jedoch ganz wesentlich miterheblich dafür, daß die Bandbreite der Phasenregelung vergrößert werden kann, was mit den weiter unten dargestellten Vorteilen verbunden ist.

Für die vorliegende Betrachtung ist noch wesentlich, daß die Vergleichsfrequenz $f_1$ gilt:

$$f_L = \frac{f_1}{L}.$$

Dem entnimmt man, daß bei dem aus dem Stand der Technik bekannten Fall, bei dem keine dem Referenzoszillator 1 bzw. dem Regeloszillator 2 nachgeschaltete Frequenzteiler 3, 4 vorgesehen sind und ein Betrieb des Referenzoszillators 1 und des Regeloszillators 2 bei nahe beieinanderliegenden Frequenzen erfolgt, die Differenzfrequenz nur um den Faktor M kleiner ist als die Vergleichsfrequenz. Im Gegensatz dazu gilt für den vorliegend beschriebenen Frequenzsynthesizer gemäß dem bevorzugten Ausführungsbeispiel der Erfindung, daß die Differenzfrequenz gegenüber der Vergleichsfrequenz nochmals deutlich kleiner ist, nämlich um den Faktor $V_1 V_2 M$. Mit den oben angegebenen Werten für $V_1$ bzw. $V_2$ von 5 bzw. 6 und 9 für M ergibt sich also eine um den Faktor 270 gegenüber der Vergleichsfrequenz geringere Differenzfrequenz.

Damit ist eine wesentlich größere Bandbreite bei der Phasenregelung erreichbar als aus dem Stand der Technik bekannt, was einerseits eine deutlich verkürzte Einschwingzeit und andererseits auch eine breitbandige Unterdrückung des Phasenrauschens des Oszillators zur Folge hat. Dabei entspricht ein geringeres Phasenrauschen auch einem verringerten "Gitter", was der Stabilität des Frequenzsynthesizers zu Gute kommt.

Wie weiter oben schon angesprochen, ist der vorliegend beschriebene Frequenzsynthesizer gemäß dem bevorzugten Ausführungsbeispiel der Erfindung auch für einen Zweileiterbetrieb geeignet, also für einen derartigen Betrieb, bei dem bei einer begrenzten Spannung von z. B. maximal 24 V Gleichspannung ein Strom im Bereich von 4 bis 20 mA fließt, wobei der Strom den jeweiligen Meßwert angibt Die damit verbundene Problematik, daß bei Ausgabe des geringsten Meßwerts von 4 mA eine elektrische Leistung von weniger als 100 mW zur Verfügung steht, kann dadurch begegnet werden, daß der Frequenzsynthesizer gemäß dem bevorzugten Ausführungsbeispiel der Erfindung intermittierend betrieben wird.

Dazu ist, wie der einzigen Figur der Zeichnung entnehmbar, eine Ansteuereinrichtung 11 vorgesehen, die einen intermittierenden Betrieb des Frequenzsynthesizers mit einer Einschwingzeit von weniger als 5 ms ermöglicht. Daß eine derart kurze Einschwingzeit mit dem vorliegend beschriebenen Frequenzsynthesizer gemäß dem bevorzugten Ausführungsbeispiel der Erfindung erzielt werden kann, ergibt sich unter anderem aus der größeren Bandbreite bei der Phasenregelung. So ist vorliegend nämlich ein Einschwingzeit von weniger als 5 ms erzielbar, während die Einschwingzeit im Stand der Technik im besten Fall bei ca. 300 ms gelegen hat.

**Patentansprüche**

1. Frequenzsynthesizer, insbesondere für einen Zeitbasisgenerator eines Füllstandsmeßgeräts, das nach dem Radar-Prinzip arbeitet, zur Ausgabe eines ersten Frequenzsignals und eines zweiten Frequenzsignals, die eine geringe Differenzfrequenz zueinander aufweisen, mit einem mit einer Referenzfrequenz betriebenen Referenzoszillator (1) und einem auf eine Regelfrequenz geregelten Regeloszillator (2), **dadurch gekennzeichnet, daß** dem Referenzoszillator (1) ein erster Frequenzteiler (3) mit dem Teilungsfaktor $V_1$ nachgeschaltet ist und dem Regeloszillator (2) ein zweiter Frequenzteiler (4) mit dem Teilungsfaktor $V_2$ nachgeschaltet ist, die der Ausgabe des ersten Frequenzsignals bzw. des zweiten Frequenzsignals dienen.

2. Frequenzsynthesizer nach Anspruch 1, **dadurch gekennzeichnet, daß** der Referenzoszillator (1) zur Ausgabe des Referenzfrequenzsignals mit einem dritten Frequenzteiler (5) mit dem Teilungsfaktor L sowie mit einem vierten Frequenzteiler (6) mit dem Teilungsfaktor N verbunden ist, der Regeloszillator (2) zur Ausgabe des Regelfrequenzsignals mit einem fünften Frequenzteiler (7) mit dem Teilungsfaktor N verbunden ist, ein Mischer (8) vorgesehen ist, der zur Zuführung des von dem vierten Frequenzteiler (6) ausgegebenen Frequenzsignals und des von dem fünften Frequenzteiler (7) ausgegebenen Frequenzsignals mit dem vierten Frequenzteiler (6) und dem fünften Frequenzteiler (7) verbunden ist, und ein Phasenfrequenzdiskriminator (9) vorgesehen ist, der zur Zuführung des von dem Mischer (8) ausgegebenen Mischdifferenzfrequenzsignals mit dem Mischer (8) und zur Zuführung des von dem dritten Frequenzteiler (5) ausgegebenen Vergleichsfrequenzsignals mit dem dritten Frequenzteiler (5) verbunden ist, wobei der Regeloszillator (2) zur Zuführung des von dem Phasenfrequenzdiskriminator (9) ausgegebenen Frequenzsignals mit dem Phasenfrequenzdiskriminator (9), vorzugsweise über einen Schleifenfilter (10), verbunden ist.

3. Frequenzsynthesizer nach Anspruch 2, **dadurch gekennzeichnet, daß** die Differenzfrequenz wenigstens um den Faktor 10, vorzugsweise wenigstens um den Faktor 30, ganz besonders bevorzugt wenigstens um den Faktor 100 kleiner gewählt ist als die Vergleichsfrequenz.

4. Frequenzsynthesizer nach Anspruch 2 oder 3, **dadurch gekennzeichnet, daß** die Teilungsfaktoren derart gewählt sind, daß der Term

$$V_1 N L \pm V_1 M N - V_2 M L$$

ganzzahlig ist, vorzugsweise vom Betrag her 1 ergibt.

5. Frequenzsynthesizer nach einem der Ansprüche 1 bis 4, **dadurch gekennzeichnet, daß** eine Ansteuereinrichtung zum intermittierenden Betrieb des Frequenzsynthesizers vorgesehen ist.

6. Verfahren zum Betrieb eines Frequenzsynthesizers, insbesondere für einen Zeitbasisgenerator eines Füllstandsmeßgeräts, das nach dem Radarprinzip arbeitet, zur Ausgabe eines ersten Frequenzsignals und eines zweiten Frequenzsignals, die eine geringe Differenzfrequenz zueinander aufweisen, mit einem mit einer Referenzfrequenz betriebenen Referenzoszillator (1) und einem auf eine Regelfrequenz geregelten Regeloszillator (2), **dadurch gekennzeichnet, daß** die Differenz zwischen der Referenzfrequenz und der Regelfrequenz wenigstens eine Größenordnung größer ist als die Differenzfrequenz zwischen dem ersten Frequenzsignal und dem zweiten Frequenzsignal.

**7.** Verfahren nach Anspruch 6, **dadurch gekennzeichnet, daß** das von dem Referenzoszillator (1) ausgegebene Referenzfrequenzsignal zur Erzeugung des ersten Frequenzsignals um den Teilungsfaktor $V_1$ heruntergeteilt wird und das von dem Regeloszillator (2) ausgegebene Regelfrequenzsignal zur Erzeugung des zweiten Frequenzsignals um den Teilungsfaktor $V_2$ heruntergeteilt wird.

**8.** Verfahren nach Anspruch 7, **dadurch gekennzeichnet, daß** zum Herunterteilen des Referenzfrequenzsignals und des Regelfrequenzsignals ein erster Frequenzteiler mit dem Teilungsfaktor $V_1$ bzw. ein zweiter Frequenzteiler mit dem Teilungsfaktor $V_2$ verwendet werden.

**9.** Verfahren nach Anspruch 8, **dadurch gekennzeichnet, daß** der Referenzoszillator (1) das Referenzfrequenzsignal auf einen dritten Frequenzteiler (5) mit dem Teilungsfaktor L sowie auf einen vierten Frequenzteiler (6) mit dem Teilungsfaktor M ausgibt, der Regeloszillator (2) das Regelfrequenzsignal auf einen fünften Frequenzteiler (7) mit dem Teilungsfaktor N ausgibt, ein Mischer (8) vorgesehen ist, dem das von dem vierten Frequenzteiler (6) ausgegebene Frequenzsignal und das von dem fünften Frequenzteiler (7) ausgegebene Frequenzsignal zugeführt wird, und ein Phasenfrequenzdiskriminator (9) vorgesehen ist, dem das von dem Mischer (8) ausgegebene Mischdifferenzfrequenzsignal und das von dem dritten Frequenzteiler (5) ausgegebene Vergleichsfrequenzsignal zugeführt wird, wobei das von dem Phasenfrequenzdiskriminator (9) ausgegebene Frequenzsignal dem Regeloszillator (2), vorzugsweise über einen Schleifenfilter (10), zugeführt wird.

**10.** Verfahren nach Anspruch 9, **dadurch gekennzeichnet, daß** die Differenzfrequenz wenigstens um den Faktor 10, vorzugsweise wenigstens um den Faktor 30, ganz besonders bevorzugt wenigstens um den Faktor 100, kleiner gewählt ist als die Vergleichsfrequenz.

**11.** Verfahren nach Anspruch 9 oder 10, **dadurch gekennzeichnet, daß** die Teilungsfaktoren derart gewählt sind, daß der Term

$$V_1 N L \pm V_1 M N - V_2 M L$$

ganzzahlig ist, vorzugsweise vom Betrag her 1 ergibt.

**12.** Verfahren nach einem der Ansprüche 6 bis 11, **dadurch gekennzeichnet, daß** der Frequenzsynthesizer intermittierend betrieben wird.

$f_{V_1}$

$f_{V_2}$

1

3 $\div V_1$

5

8

7

4 $\div V_2$

2

$f_1$ $\sim$

$\div M$

$\otimes$

$\div N$

$f_2$ $\sim$

$\div L$ $f_L$

PFD

F(s)

6

9

10

11

**EUROPÄISCHER RECHERCHENBERICHT**

Nummer der Anmeldung

EP 05 01 0425

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | EP 1 098 440 A (KROHNE S.A)<br>9. Mai 2001 (2001-05-09)<br>* Absatz [0016] - Absatz [0024]; Abbildung * | 1,5-8,12 | H03L7/18<br>G01F23/284 |
| Y | | 2-4,9-11 | |
| | ----- | | |
| X | US 5 457 990 A (OSWALD ET AL)<br>17. Oktober 1995 (1995-10-17)<br>* Spalte 6, Zeile 28 - Spalte 8, Zeile 19 *<br>* Spalte 10, Zeile 35 - Zeile 41 *<br>* Abbildungen 7-10a * | 1,5-8,12 | |
| Y | | 2-4,9-11 | |
| | ----- | | |
| Y,D | DE 102 44 348 A1 (MUSCH, THOMAS; SCHIEK, BURKHARD) 1. April 2004 (2004-04-01)<br>* Absatz [0003] - Absatz [0013] *<br>* Abbildung 1 * | 2-4,9-11 | |
| | ----- | | |
| A | US 4 893 094 A (HEROLD ET AL)<br>9. Januar 1990 (1990-01-09)<br>* Spalte 3, Zeile 47 - Spalte 6, Zeile 13 *<br>* Abbildungen 1,4 * | 5,12 | RECHERCHIERTE SACHGEBIETE (Int.Cl.7)<br><br>H03L<br>G01F |
| | ----- | | |

Der vorliegende Recherchenbericht wurde für alle Patentansprüche erstellt

| Recherchenort | Abschlußdatum der Recherche | Prüfer |
|---|---|---|
| Den Haag | 22. September 2005 | Balbinot, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.........................................................

& : Mitglied der gleichen Patentfamilie, übereinstimmendes Dokument

**ANHANG ZUM EUROPÄISCHEN RECHERCHENBERICHT
ÜBER DIE EUROPÄISCHE PATENTANMELDUNG NR.**                    EP 05 01 0425

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

22-09-2005

| Im Recherchenbericht angeführtes Patentdokument | | Datum der Veröffentlichung | Mitglied(er) der Patentfamilie | | Datum der Veröffentlichung |
|---|---|---|---|---|---|
| EP 1098440 | A | 09-05-2001 | CA<br>DE<br>US | 2324906 A1<br>19952826 C1<br>6404288 B1 | 03-05-2001<br>12-04-2001<br>11-06-2002 |
| US 5457990 | A | 17-10-1995 | KEINE | | |
| DE 10244348 | A1 | 01-04-2004 | KEINE | | |
| US 4893094 | A | 09-01-1990 | CA<br>EP<br>JP<br>WO | 2046294 A1<br>0464139 A1<br>4505840 T<br>9010978 A1 | 14-09-1990<br>08-01-1992<br>08-10-1992<br>20-09-1990 |

EPO FORM P0461

Für nähere Einzelheiten zu diesem Anhang : siehe Amtsblatt des Europäischen Patentamts, Nr.12/82